Europäisches Patentamt

European Patent Office

Office européen des brevets

(11) Numéro de publication: **0 140 829**
**A1**

## (12) DEMANDE DE BREVET EUROPEEN

(21) Numéro de dépôt: **84810413.9**

(22) Date de dépôt: **22.08.84**

(51) Int. Cl.⁴: **B 23 P 19/00**

(30) Priorité: **26.08.83 CH 4691/83**

(43) Date de publication de la demande: **08.05.85 Bulletin 85/19**

(84) Etats contractants désignés: **IT**

(71) Demandeur: **C O D Inter Techniques SA, 16, rue Albert Gos, CH-1206 Genève (CH)**

(72) Inventeur: **Horvath, Laszlo S., 51 rte de Frontenex, CH-1207 Genève (CH)**

(74) Mandataire: **Vuille, Roman et al, c/o KIRKER & Cie S.A. 14, rue du Mont-Blanc Case Postale 872, CH-1211 Genève 1 (CH)**

(54) **Robot d'assemblage comprenant un dispositif de transport collectif des pièces à assembler, procédé d'assemblage et son application.**

(57) Un robot destiné à l'assemblage de pièces constitutives d'objets comprend au moins une tête de travail (4) pourvue d'un outil (8) effectuant au-dessus d'une aire de travail (9) des mouvements commandés par un programme selon au moins trois degrés de liberté et, dans ladite aire de travail (9), un dispositif (14) assurant le positionnement exact des pièces à manipuler dans des positions et des orientations prédéterminées. Il se caractérise en ce qu'il comporte au moins un réceptacle préformé amovible (17) assurant le transport collectif des pièces à assembler vers ou hors de l'aire de travail (9), réceptacle conformé pour maintenir avec un certain jeu lesdites pièces dans des positions et des orientations relatives semblables à celles déterminées par le dispositif (14) et agencé pour coopérer avec ce dernier.

Procédé d'assemblage mettant en œuvre un robot tel que défini ci-dessus et son application à l'assemblage en séries de pièces constitutives d'objets.

## Robot d'assemblage comprenant un dispositif
## de transport collectif des pièces à assembler,
## procédé d'assemblage et son application

La présente invention se rapporte à un robot destiné à l'assemblage de pièces constitutives d'objets, à un procédé d'assemblage mettant en oeuvre un tel robot, ainsi qu'à l'application dudit procédé à l'assemblage en séries de pièces constitutives d'objets.

De nos jours, l'emploi des robots industriels se diversifie toujours plus: de nouvelles branches de l'industrie introduisent progressivement de tels robots dans des domaines jusqu'alors inexploités; d'autre part, les tâches confiées à ces robots évoluent elles-mêmes pour devenir plus complexes, plus délicates ou nécessiter plus de précision par exemple. Dans la manipulation d'objets en grandes séries, des opérations telles qu'assemblage, emboîtage, vissage ou soudure par exemple, nécessitent une très grande précision. Dans de telles opérations, la position desdits objets sur l'aire de travail proprement dite doit être, en effet, assurée avec des tolérances des plus minimes.

Si le positionnement des pièces à assembler peut être réalisé dans l'aire de travail avec toute l'exactitude voulue à l'aide d'un dispositif de positionnement approprié, le traitement d'objets en grandes séries demande nombre de manipulations accessoires complexes qui ralentissent d'autant l'ensemble des opérations effectuées. Le problème à résoudre actuellement se situe au niveau du transport des pièces à assembler sur l'aire de travail et à leur mise en contact avec certains des éléments constitutifs du dispositif de positionnement, dans les positions et les orientations déterminées en fonction des opérations d'assemblage subséquentes. La mise en place desdites pièces s'effectue encore très souvent à la main; dans d'autres cas, notamment lors du transport et de la mise en place de séries de pièces sur l'aire de travail, on a recours à l'emploi de palettes, le cas échéant préformées, assurant également le positionnement desdites pièces, telles des palettes en matériau thermoplastique par exemple. Les techniques actuelles, moulage ou thermoformage par exemple, ne permettent cependant pas d'obtenir des palettes dont la forme s'adapte avec suffisamment d'exactitude à celle des pièces à manipuler, plus particulièrement lorsque certaines des opérations citées plus haut doivent être effectuées. En fait, les robots d'assemblage connus à ce jour ne permettent pas d'assurer le transport collectif et le positionnement collectif de séries de pièces à assembler dans des conditions rationnelles. Ces lacunes sont avantageusement comblées par le robot selon la présente invention et sa mise en oeuvre.

La présente invention a plus précisément pour objet un robot destiné à l'assemblage de pièces constitutives d'objets, comprenant au moins une tête de travail pourvue d'un outil effectuant au-dessus d'une aire de travail des mouvements commandés par un programme selon au moins trois degrés de liberté et comprenant, dans ladite aire de travail, un dispositif assurant le positionnement exact des pièces à manipuler dans des positions et des orientations prédéterminées, caractérisé en ce qu'il comporte au moins un réceptacle préformé amovible assurant le transport collectif des pièces à assembler vers ou hors de l'aire de travail, conformé pour maintenir avec un certain jeu lesdites pièces dans des positions et des orientations relatives semblables à celles déterminées par le dispositif et agencé pour coopérer avec ce dernier.

Les dessins annexés illustrent à titre purement indicatif certaines des exécutions du robot défini ci-dessus.

Figure 1 représente vu de profil un robot selon la présente invention.

Figure 2 représente vu en plan le robot illustré par Fig. 1.

Figures 3 et 4, respectivement 5 et 6, illustrent soit en plan, soit en profil, le détail de deux exécutions particulières du robot selon l'invention.

3

0140829

Figures 7, respectivement 8 et 9 illustrent, vu en plan et en profil, le détail d'une autre exécution du robot selon l'invention.

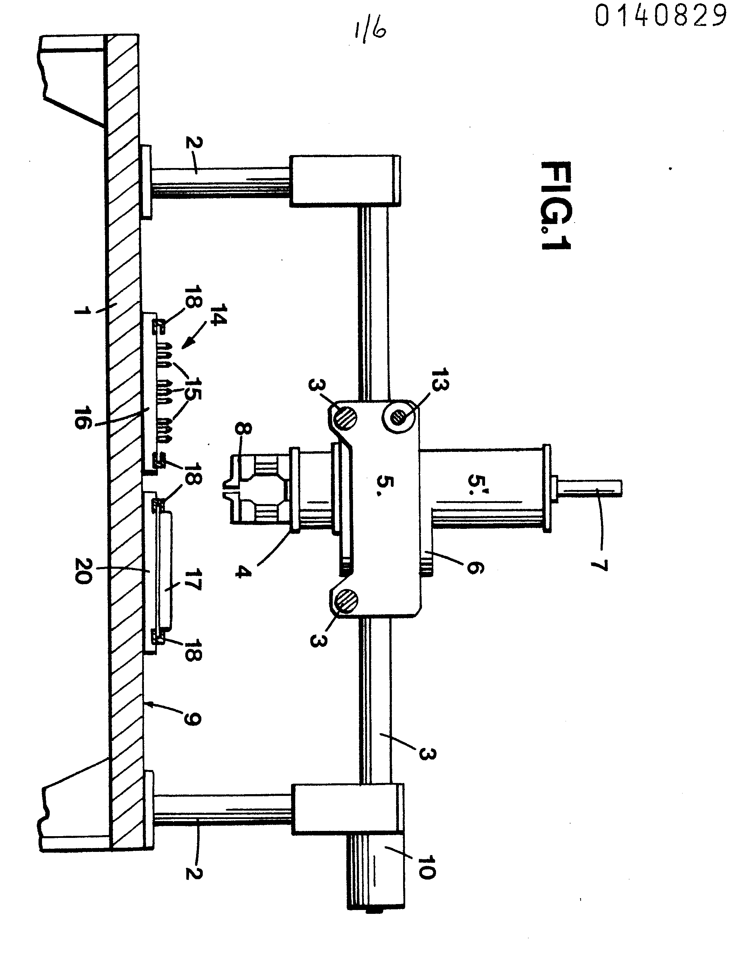

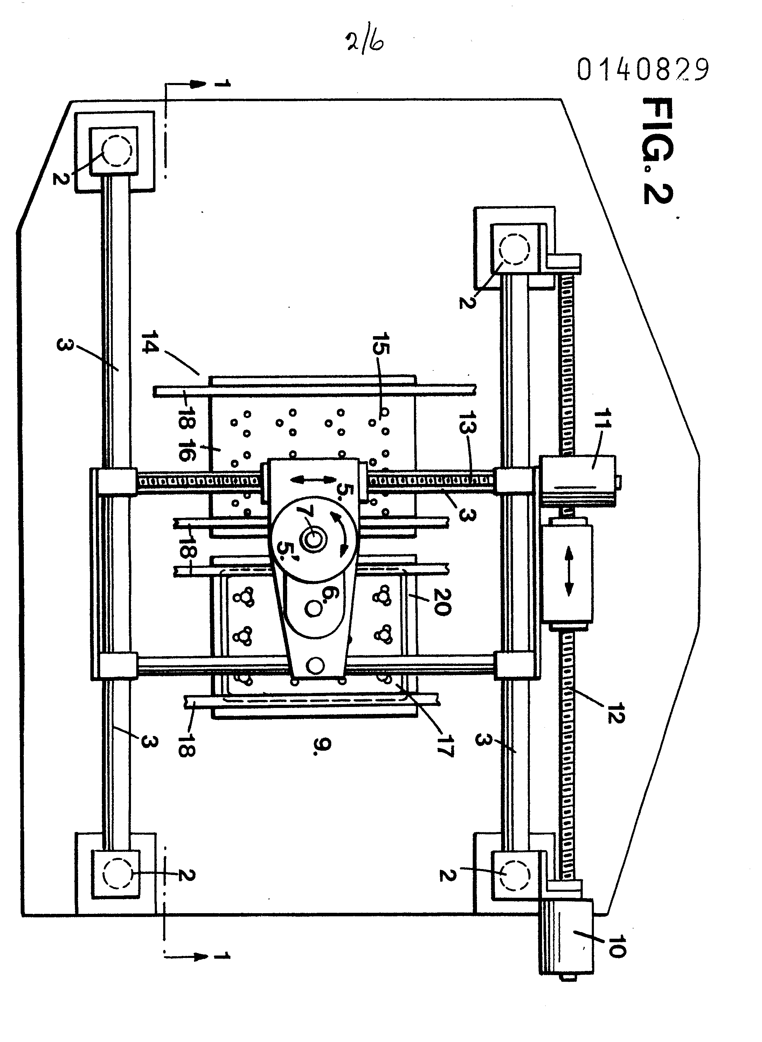

Tel que représenté par Fig. 1 et 2, le robot comporte un bâti 1, supportant des montants 2 eux-mêmes porteurs de moyens 3 assurant le guidage d'au moins une tête de travail 4. Ladite tête de travail comporte un corps principal 5 coopérant avec les moyens de guidage 3, surmonté d'un boîtier 5' et d'un moteur 6 ou de tout autre dispositif pouvant assurer la rotation de ladite tête de travail autour de son axe 7. C'est par exemple par l'intermédiaire de cet axe 7 que la tête 4 peut être reliée aux divers moyens de commande. Dans l'exécution représentée, la tête 4 est pourvue d'une pince de préhension 8.

Les divers mouvements de la tête de travail 4, qui peut se déplacer au-dessus de l'aire de travail 9 avec trois degrés de liberté au moins, sont engendrés et contrôlés à l'aide des instruments usuels tels des servomoteurs 10, 11 entraînant des vis sans fin 12, 13 par exemple. La tête de travail 4 et ses éléments annexes prennent appui sur les éléments 12, respectivement 13 et sur les moyens de guidage appropriés 3 de façon usuelle; le glissement sur les moyens 3 peut être assuré par exemple à l'aide de roulements conventionnels. Les mouvements de la tête de travail 4, de même que ceux de l'outil 8, sont commandés par un programme. L'ensemble du système est en outre contrôlé par un ou plusieurs microprocesseurs, voire un ordinateur.

Le robot comporte sur au moins une partie de l'aire de travail 9 un dispositif de positionnement exact 14 des objets à manipuler. Ce dispositif 14 comprend des éléments rigides espacés 15, solidaires d'un support amovible 16. Ledit support 16 est en effet de préférence amovible afin de pouvoir être substitué en temps voulu à un autre support 16 sur lequel l'arrangement des éléments rigides 15 est différent: on peut de ce fait adapter en tout temps le dispositif 14 à la forme particulière des objets à manipuler. Selon les besoins en outre, la fixa-

4

0140829

tion du support 16 au bâti 1 peut être assurée par tout moyen adéquat tel que vis, crochets ou aimants par exemple.

Les éléments rigides 15 sont disposés perpendiculairement à la surface de l'aire de travail 9, s'élevant au-dessus du support 16. Lesdits éléments 15 peuvent consister par exemple en des goupilles de forme conique, tronconique, cylindrique ou prismatique par exemple, convenablement solidarisées audit support; de telles goupilles peuvent être vissées ou soudées au support 16 ou chassées au travers de ce dernier par exemple. En outre, le support amovible 16 sera conçu de façon à pouvoir supporter une contrainte mécanique.

L'arrangement des éléments 15 à la surface du support 16 sera fonction de la nature des objets à manipuler, notamment de leur forme, ainsi que de l'orientation à leur donner.

Selon l'invention, le robot comprend au moins un réceptacle préformé amovible 17, assurant le transport collectif des pièces à assembler vers ou hors de l'aire de travail 9, et conformé pour maintenir avec un certain jeu lesdites pièces dans des positions et des orientations relatives semblables à celles déterminées par le dispositif 14. Ledit réceptacle 17 est en outre agencé pour coopérer avec le dispositif 14 mentionné ci-dessus.

Le réceptacle 17 peut se présenter par exemple sous la forme d'un plateau en matériau thermoformable, présentant des perforations 21 conformées pour être traversées par les éléments 15 lorsque ledit réceptacle prend appui sur le support 16, ainsi que des godets 22 récepteurs des pièces à manipuler et définissant des espaces suffisants pour accepter un léger déplacement desdites pièces sous l'effet du dispositif de positionnement 14.

En fonction des tâches assignées au robot d'assemblage, le réceptacle 17 sera conformé pour assurer le transport d'une ou plusieurs séries de pièces identiques, ou d'une ou plusieurs séries de pièces différentes les unes des autres.

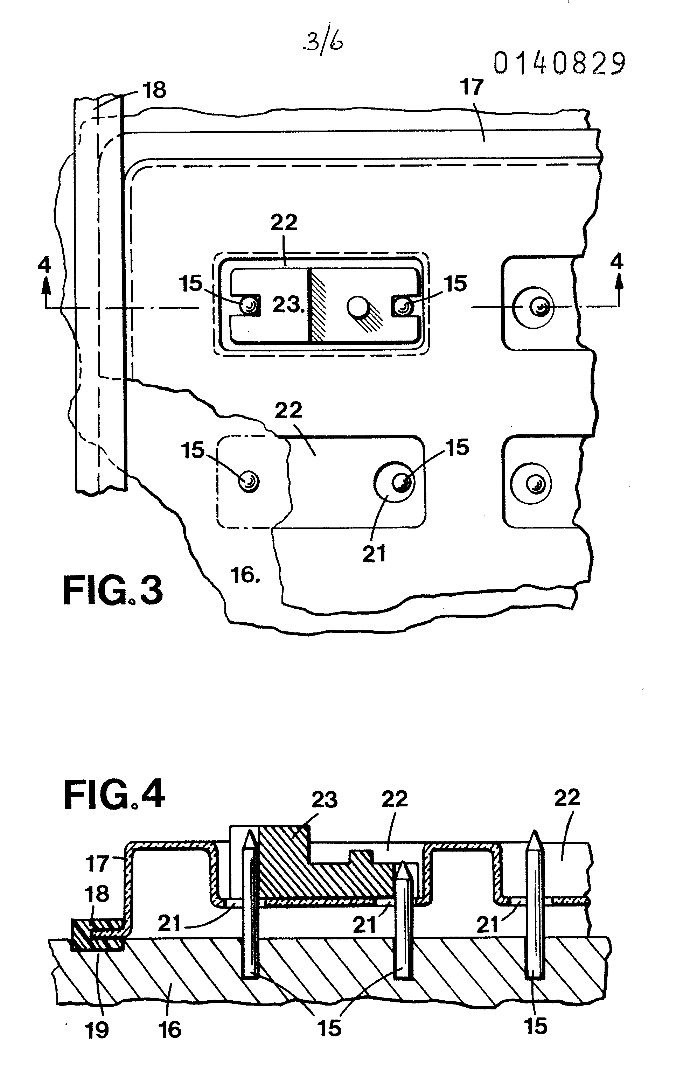

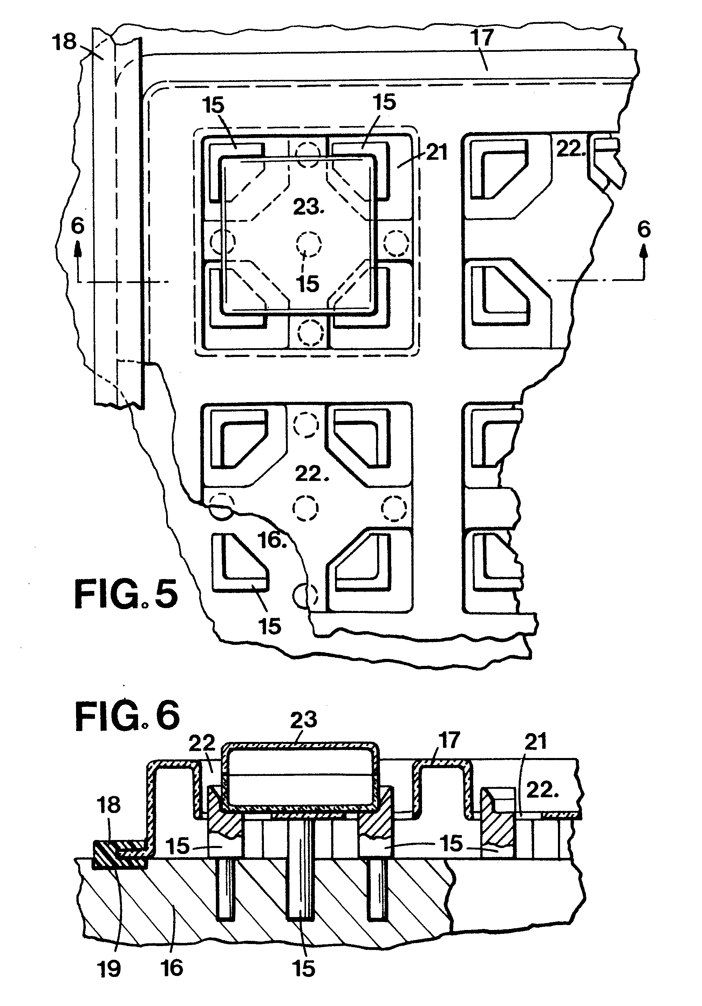

Le déroulement des opérations relatives au transport et au positionnement exact des pièces à assembler peut être décrit comme suit (Fig. 3 à 6): préalablement rempli, hors de l'aire de travail 9, avec les pièces sélectionnées 23, le réceptacle préformé 17 est amené sur l'aire de travail 9, par exemple à l'aide de courroies 18 coulissant dans des guides appropriés ou des gorges 19 aménagées dans l'élément 16 du dispositif de positionnement 14, respectivement une plaque de dépose 20 par exemple. Le maintien du réceptacle 17 peut être par exemple réalisé par pincement ou tout autre moyen adéquat et les déplacements dudit réceptacle contrôlés par le dispositif de commande du robot.

Une fois amené au-dessus du dispositif 14, le réceptacle 17 préformé et perforé est alors abaissé jusqu'à la hauteur voulue, les éléments rigides 15, des goupilles cylindriques à tête conique par exemple, passant alors au travers des perforations 21 aménagées dans les godets 22. Les pièces 23 entrent alors en contact étroit avec lesdits éléments 15 et coulissent le long de ceux-ci pour prendre finalement la position définie avec exactitude par l'ensemble des éléments 15. Dans une autre exécution de l'invention, on peut concevoir un dispositif 14 subissant une translation verticale, le réceptacle 17 demeurant posé sur la surface 9 du bâti 1.

Une fois les opérations d'assemblage terminées, le réceptacle 17 peut être retiré de l'aire de travail, acheminant les objets terminés vers une zone de dépose par exemple.

Selon les cas, les éléments rigides 15 peuvent servir à assurer aussi bien le positionnement latéral des objets à manipuler que leur positionnement en hauteur. Les perforations 21 aménagées dans les réceptacles 22 présentent de préférence une section légèrement supérieure à celle des éléments 15 du dispositif 14 auxquelles elles correspondent.

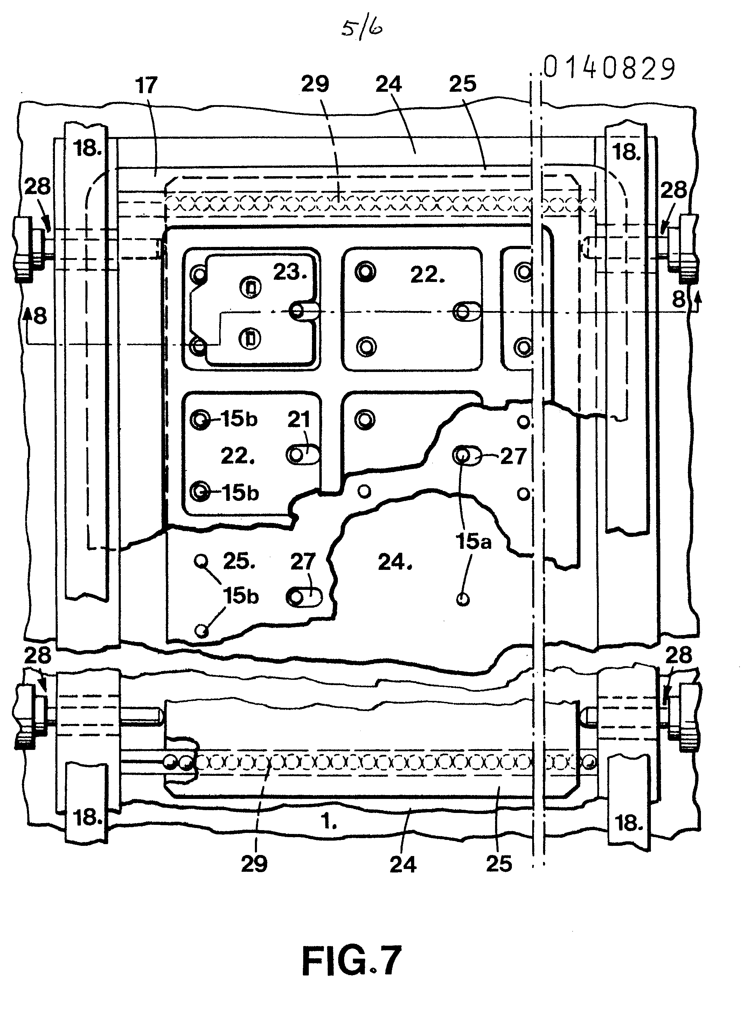

Dans une autre exécution du robot selon l'invention (Fig. 7 à 9), le dispositif de positionnement 14 comporte un support amovible 16 se composant de deux plaques

6

0140829

superposées 24, 25 porteuses d'éléments rigides espacés 15a, respectivement 15b, lesdites plaques étant agencées de façon à pouvoir se déplacer l'une par rapport à l'autre selon un axe au moins de leur surface de contact commune 26. Les déplacements relatifs des plaques 24 et 25 peuvent être réalisés à l'aide de tout moyen adéquat, tels par exemple des moyens 28 comprenant un ou plusieurs vérins actionnant la plaque mobile 25 par deux de ses côtés. Des moyens de guidage 29 assureront en outre le déplacement de ladite plaque mobile 25 selon l'axe désiré: de tels moyens peuvent par exemple comprendre une ou plusieurs goupilles engagées dans des rainures correspondantes, ou une série de billes coopérant avec des gorges aménagées dans la face supérieure, respectivement inférieure, de la plaque 24, respectivement 25 (Fig. 7). La commande de tels mouvements peut être programmée en fonction du déroulement des opérations d'assemblage.

Dans cette exécution particulière, la plaque supérieure 25 présente des perforations 27 traversées par les éléments 15a solidaires de la plaque 24. La section desdites perforations 27 ainsi que celle des perforations 21 du réceptacle 17 sont alors calculées de façon à pouvoir absorber la course maximum de la plaque 25 nécessaire au serrage des pièces 23 entre les éléments rigides 15a, 15b.

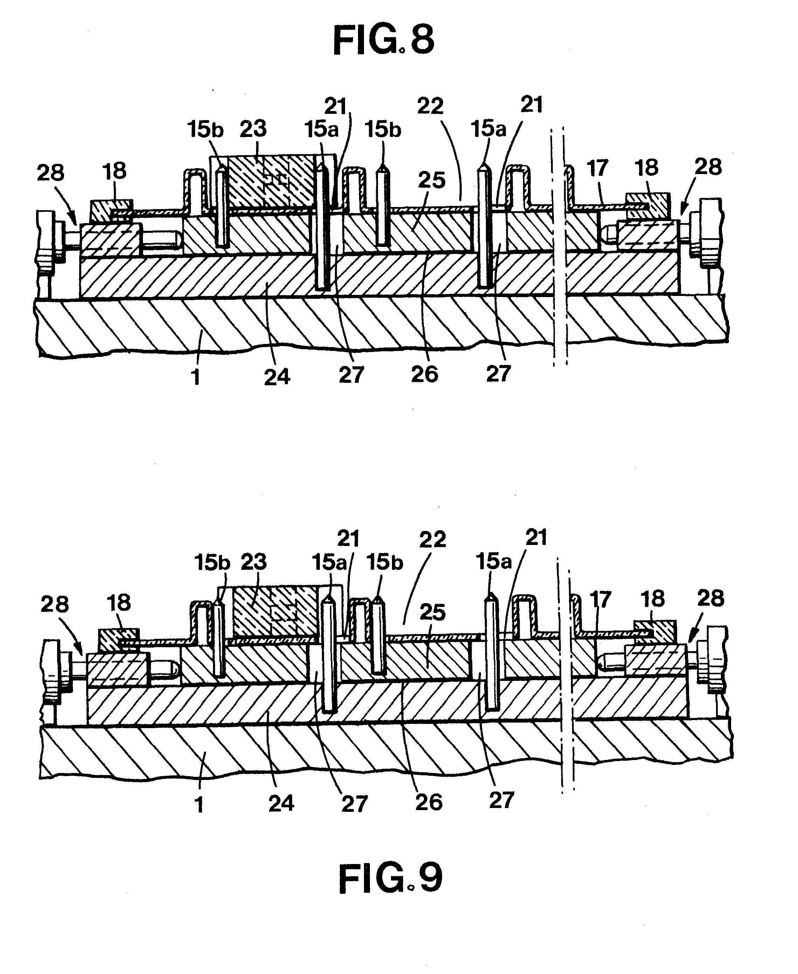

Figure 8, qui est une coupe selon 8,8 de Figure 7, illustre la situation dans laquelle lesdites pièces 23 sont serrées entre les éléments 15a, 15b. Dans Fig. 9, les éléments sont écartés les uns des autres sous l'effet des moyens 28 et les pièces 23 dégagées desdits éléments 15a, 15b.

Le déroulement des opérations de transport, avant et après assemblage des pièces 23, est identique à celui décrit précédemment, l'exactitude du positionnement et des orientations relatives desdites pièces 23 étant assuré par un effet de serrage des éléments 15a, 15b.

Il a été constaté que l'application du procédé d'assemblage mettant en oeuvre le robot selon l'invention était particulièrement bien adaptée à l'assemblage en séries de pièces constitutives d'objets, notamment de grandes séries. Il est évident que ledit procédé peut également s'appliquer à l'assemblage, pièce par pièce, d'un seul objet à la fois.

REVENDICATIONS

1. Robot destiné à l'assemblage de pièces constitutives d'objets, comprenant au moins une tête de travail (4) pourvue d'un outil (8) effectuant au-dessus d'une
aire de travail (9) des mouvements commandés par un programme selon au moins trois degrés de liberté et comprenant, dans ladite aire de travail (9), un dispositif (14)
assurant le positionnement exact des pièces à manipuler
dans des positions et des orientations prédéterminées,
caractérisé en ce qu'il comporte au moins un réceptacle
préformé amovible (17) assurant le transport collectif des
pièces à assembler vers ou hors de l'aire de travail (9),
conformé pour maintenir avec un certain jeu lesdites
pièces dans des positions et des orientations relatives
semblables à celles déterminées par le dispositif (14) et
agencé pour coopérer avec ce dernier.

2. Robot selon la revendication 1, caractérisé
en ce que le dispositif de positionnement (14) comprend
des éléments rigides espacés (15) solidaires d'un support
amovible (16), conçu pour supporter une contrainte mécanique, et disposés perpendiculairement à la surface dudit
support (16), et que le réceptacle (17) présente des perforations (21) conformées pour être traversées par les
éléments (15) lorsque le réceptacle (17) prend appui sur
le support (16).

3. Robot selon l'une des revendications 1 et 2,
caractérisé en ce que le dispositif de positionnement (14)
comporte un support amovible (16) se composant de deux
plaques superposées (24, 25) porteuses d'éléments rigides
espacés (15a), respectivement (15b), lesdites plaques
étant agencées de façon à pouvoir se déplacer l'une par
rapport à l'autre selon un axe au moins de leur surface de
contact commune (26).

4. Robot selon la revendication 3, caractérisé
en ce que la plaque supérieure (25) présente des perforations (27) traversées par les éléments (15a) solidaires de
la plaque (24), et que la section desdites perforations
(27) ainsi que celle des perforations (21) du réceptacle (17) sont calculées de façon à pouvoir absorber la course maximum de la plaque (25) nécessaire au serrage des pièces entre les éléments rigides (15a, 15b).

5. Robot selon l'une des revendications 1 à 4, caractérisé en ce que le réceptacle (17) présente des godets (22) récepteurs des pièces à manipuler et définissant des espaces suffisants pour accepter un déplacement des pièces à manipuler sous l'effet du dispositif de positionnement (14).

6. Procédé d'assemblage de pièces constitutives d'objets selon lequel lesdites pièces sont maintenues dans une aire de travail (9) dans des positions et des orientations exactes à l'aide d'un dispositif de positionnement (14) en vue de leur manipulation par au moins un outil (8) monté sur une tête de travail (4) effectuant des mouvements commandés par un programme, caractérisé en ce que l'on dispose lesdites pièces, préalablement à leur assemblage et hors de l'aire de travail (9), dans un réceptacle (17) conformé pour coopérer avec le dispositif de positionnement (14) et pour maintenir avec un certain jeu lesdites pièces dans des positions et des orientations relatives semblables à celles déterminées par le dispositif (14), on amène le réceptacle (22) dans l'aire de travail (9), on dispose ensuite ledit réceptacle dans l'aire de travail de façon à mettre chacune des pièces contenues dans le réceptacle en contact direct avec une partie au moins des éléments du dispositif de positionnement (14) et, le cas échéant, on retire le réceptacle (22) de l'aire de travail (9) une fois les opérations d'assemblage terminées.

7. Procédé selon la revendication 6, caractérisé en ce que le dispositif de positionnement (14) comprend des éléments rigides espacés (15) solidaires d'un support amovible (16), conçu pour supporter une contrainte mécanique, et disposés perpendiculairement à la surface dudit support (16), et que le réceptacle (17) présente des perforations (21) conformées pour être traversées par les éléments (15) lorsque le réceptacle (17) prend appui sur le support (16).

0140829

8. Procédé selon l'une des revendications 6 et 7, caractérisé en ce que le réceptacle (17) est conformé pour transporter une ou plusieurs séries de pièces identiques.

9. Procédé selon l'une des revendications 6 et 7, caractérisé en ce que le réceptacle (17) est conformé pour transporter une ou plusieurs séries de pièces distinctes les unes des autres.

10. Application du procédé selon l'une des revendications 6 à 9 à l'assemblage en série de pièces constitutives d'objets.

**FIG.1**

0140829

1/6

FIG. 2

0140829

2/6

FIG.3

FIG.4

0140829

**FIG. 5**

**FIG. 6**

0140829

**FIG. 7**

# FIG. 8

# FIG. 9

**Office européen des brevets**

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | BE-A- 666 913 (PHILIPS) <br> * En entier * | 1,6 | B 23 P 19/00 |
| A | DE-A-2 915 366 (TAKAHASHI TETSUO) | | |
| P,A | WO-A-8 402 249 (WESTERN ELECTRIC) | | |
| A | US-A-4 173 824 (WOLFTHAL) | | |
| A | US-A-1 518 917 (GRIFFIN) | | |

DOMAINES TECHNIQUES RECHERCHES (Int. Cl.4)

B 23 P
H 05 K
B 23 Q
B 23 K

Le présent rapport de recherche a été établi pour toutes les revendications

| Lieu de la recherche <br> LA HAYE | Date d'achèvement de la recherche <br> 28-11-1984 | Examinateur <br> BERGHMANS H.F. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82